# EUROPEAN PATENT APPLICATION

(11) **EP 4 326 019 A1**
(43) Date of publication of application: **21.02.2024**
(21) Application number: 22200223.0
(22) Date of filing: 07.10.2022
(51) Int. Cl.: H05K 7/20

(54) **HEAT DISSIPATION SYSTEM**

(30) Priority: 15.08.2022 TW 111130524
(71) Applicant: Giga Computing Technology Co., Ltd., New Taipei City 231 (TW)
(72) Inventor: LIN, Jian-Hung, 231 New Taipei City (TW); YANG, Chao-Chiang, 231 New Taipei City (TW); HOU, Chih-Jen, 231 New Taipei City (TW); HUANG, Ching-Chuan, 231 New Taipei City (TW); ADACHI, Nobuhiro, 231 New Taipei City (TW)
(74) Representative: Becker, Eberhard

(57) **Abstract**

A heat dissipation system (100, 100a, 100b) adapted to dissipate heat for an electronic device (10) includes a tank (110), a first heat exchanger (120, 120a, 120b), and a fluid delivery device (130). The tank (110) includes a first zone (111, 111a, 111b) and a second zone (112, 112a, 112b). A cooling fluid is located in the first and second zones (111, 111a, 111b, 112, 112a, 112b). The electronic device (10) is adapted to be disposed in the first zone (111, 111a, 111b) and immersed in the cooling fluid. The first heat exchanger (120, 120a, 120b) is located at a junction of the first and second zones (111, 111a, 111b, 112, 112a, 112b) to reduce a temperature of the cooling fluid. The cooling fluid flows from the first zone (111, 111a, 111b) to the second zone (112, 112a, 112b) through the fluid delivery device (130).

## Description

### BACKGROUND

### Technical Field

The disclosure relates to a heat dissipation system, and more particularly, to a heat dissipation system that provides a fluid cycle.

### Description of Related Art

At present, electronic devices (such as servers) that generate high heat may be dissipated by being connected to cooling pipelines. However, in order to dispose the cooling pipelines, in addition to being limited by the size of the space, an issue of complicated piping is also caused by factors such as a location of a heat source of the electronic device. In addition, there is a risk of leakage of a cooling fluid at junctions of the cooling pipelines, and the complicated cooling pipelines are difficult to repair or replace.

### SUMMARY

The disclosure provides a heat dissipation system in which a cooling fluid flows directly in different zones of a tank to form a cycle of the cooling fluid without a complicated configuration of cooling pipelines.

A heat dissipation system in the disclosure adapted to dissipate heat for an electronic device includes a tank, a first heat exchanger, and a fluid delivery device. The tank includes a first zone and a second zone. A cooling fluid is located in the first zone and the second zone, and the electronic device is adapted to be disposed in the first zone and immersed in the cooling fluid. The first heat exchanger is disposed at a junction of the first zone and the second zone to reduce a temperature of the cooling fluid. The cooling fluid flows from the first zone to the second zone through the fluid delivery device. The cooling fluid is adapted to flow to the first zone from the second zone after passing through the first heat exchanger, so as to dissipate the heat for the electronic device, and then flows to the second zone through the fluid delivery device, such that a cycle is formed.

In an embodiment of the disclosure, the tank includes an inner partition plate and a communication opening adjacent to a bottom of the tank. The inner partition plate separates the tank into a main tank and a secondary tank. The main tank is communicated to the secondary tank through the communication opening, and the electronic device is disposed in the main tank.

In an embodiment of the disclosure, the first heat exchanger is disposed in the main tank. The first zone covers a portion of the main tank, and the second zone covers another portion of the main tank and the secondary tank.

In an embodiment of the disclosure, a fluid level of the cooling fluid in the secondary tank is higher than a fluid level of the cooling fluid in the main tank, so that the cooling fluid in the secondary tank flows to the main tank through the communication opening, and passes through the first heat exchanger.

In an embodiment of the disclosure, the first heat exchanger is disposed in the secondary tank. The first zone covers the main tank and a portion of the secondary tank, and the second zone covers another portion of the secondary tank.

In an embodiment of the disclosure, a fluid level of the cooling fluid in the second zone is higher than a fluid level of the cooling fluid in the main tank, and the cooling fluid in the second zone passes through the first heat exchanger and flows to the main tank through the communication opening.

In an embodiment of the disclosure, the heat dissipation system further includes a uniform flow plate disposed in the main tank adjacent to the communication opening.

In an embodiment of the disclosure, the tank includes a third zone, and the heat dissipation system further includes a second heat exchanger disposed at a junction of the second zone and the third zone. The fluid delivery device delivers the cooling fluid from the first zone to the third zone. The cooling fluid flows to the second zone from the third zone after passing through the second heat exchanger, then flows to the first zone after passing through the first heat exchanger, so as to dissipate the heat for the electronic device, and is delivered to the third zone by the fluid delivery device, such that the cycle is formed.

In an embodiment of the disclosure, the tank includes an inner partition plate and a communication opening located at a bottom of the tank. The inner partition plate separates the tank into a main tank and a secondary tank. The main tank is communicated to the secondary tank through the communication opening. The electronic device is disposed in the main tank. The first heat exchanger is disposed in the main tank, and the second heat exchanger is disposed in the secondary tank.

In an embodiment of the disclosure, the first zone covers a portion of the main tank. The second zone covers another portion of the main tank and a portion of the secondary tank. The third zone covers another portion of the secondary tank.

In an embodiment of the disclosure, a fluid level of the cooling fluid in the third zone is higher than a fluid level of the cooling fluid in the main tank. The cooling fluid flows to the second zone from the third zone through the second heat exchanger, flows to the main tank through the communication opening, and flows to the first zone through the first heat exchanger.

Based on the above, in the heat dissipation system according to the disclosure, the first heat exchanger is disposed at the junction of the first zone and the second zone of the tank to reduce the temperature of the cooling fluid flowing to the first zone. The electronic device may be disposed in the first zone to achieve a heat dissipation effect. The warmed cooling fluid flows from the first zone to the second zone through the fluid delivery device. In the heat dissipation system according to the disclosure, the cooling fluid is adapted to flow to the first zone from the second zone after passing through the first heat exchanger, so as to dissipate the heat for the electronic device immersed in the cooling fluid in the first zone, and then the cooling fluid flows to the second zone through the fluid delivery device, such that the cycle is formed. Therefore, the heat dissipation system according to the disclosure does not require the complicated cooling pipelines, and the overall structure is quite simple.

### BRIEF DESCRIPTION OF THE DRAWINGS

FIG. 1 is a schematic view of a heat dissipation system according to an embodiment of the disclosure.
FIGs. 2 to 4 are schematic views of a heat dissipation system from different viewing angles according to another embodiment of the disclosure.
FIGs. 5 to 6 are schematic views of a heat dissipation system from different viewing angles according to another embodiment of the disclosure.

### DETAILED DESCRIPTION OF DISCLOSED EMBODIMENTS

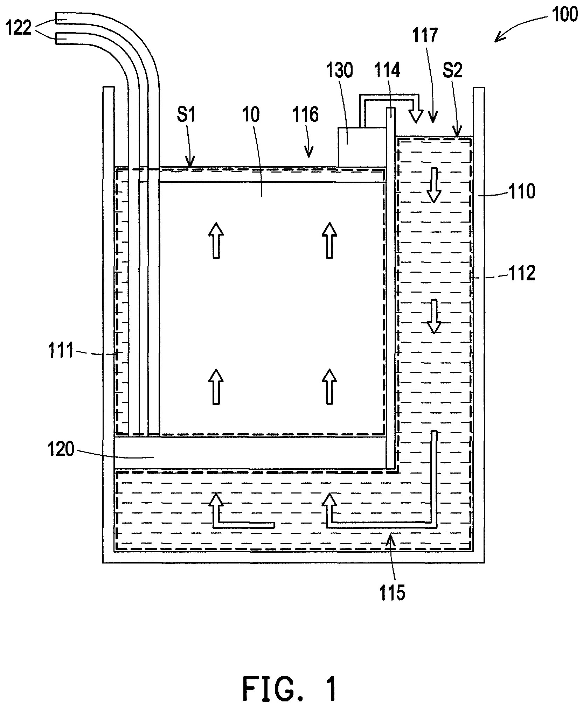

FIG. 1 is a schematic view of a heat dissipation system according to an embodiment of the disclosure. Referring to FIG. 1, a heat dissipation system 100 in this embodiment is adapted to dissipate heat for an electronic device 10. The electronic device 10 is, for example, a server, but a type of the electronic device 10 is not limited thereto.

The heat dissipation system 100 includes a tank 110, a first heat exchanger 120, and a fluid delivery device 130. The tank 110 includes an inner partition plate 114 and a communication opening 115 adjacent to a bottom of the tank. The inner partition plate 114 separates the tank 110 into a main tank 116 and a secondary tank 117. A volume of the main tank 116 is greater than a volume of the secondary tank 117. The main tank 116 is communicated to the secondary tank 117 through the communication opening 115, and the electronic device 10 is disposed in the main tank 116.

On the other hand, in this embodiment, the tank 110 includes a first zone 111 and a second zone 112, and the first heat exchanger 120 is disposed at a junction of the first zone 111 and the second zone 112. That is to say, the first zone 111 and the second zone 112 are demarcated by a position where the first heat exchanger 120 is disposed in the tank 110.

According to FIG. 1, in this embodiment, the first heat exchanger 120 is disposed in the main tank 116, and the first zone 111 covers a portion of the main tank 116 (which is a portion of the main tank 116 above the first heat exchanger 120). The second zone 112 covers another portion of the main tank 116 (which is a portion of the main tank 116 below the first heat exchanger 120) and the secondary tank 117.

A cooling fluid is located in the first zone 111 and the second zone 112. The electronic device 10 is adapted to be disposed in the first zone 111 and immersed in the cooling fluid to exchange the heat with the cooling fluid. The first heat exchanger 120 is configured to reduce a temperature of the passing cooling fluid. Therefore, the cooling fluid is adapted to flow to the first zone 111 at a lower temperature from the second zone 112 after passing through the first heat exchanger 120, so as to dissipate the heat for the electronic device 10.

Since the electronic device 10 generates the heat during operation, the temperature of the cooling fluid in the first zone 111 increases. In this embodiment, the cooling fluid may flow from the first zone 111 to the second zone 112 through the fluid delivery device 130 (for example, a pump, but is not limited thereto), then pass through the first heat exchanger 120 to reduce the temperature, and flow to the first zone 111, such that a cycle of the cooling fluid is formed.

In this embodiment, the first heat exchanger 120 includes, for example, multiple fins, and cooling liquid inlet and outlet pipes 122 pass through the fins to cool the fins. In other embodiments, a type of the first heat exchanger 120 is not limited thereto. The first heat exchanger 120 may also increase a heat dissipation area through other structures, as long as the first heat exchanger 120 has a channel or a through hole to allow the cooling fluid to pass through.

It is worth mentioning that in this embodiment, a method in which the cooling fluid passes through the first heat exchanger 120 through the heat dissipation system 100 is, for example, by adjusting an extraction rate or an extraction volume of the cooling fluid by the fluid delivery device 130, or/and using with a size of the channel (e.g., a channel size between the fins) of the first heat exchanger 120, so that a fluid level S2 of the cooling fluid in the secondary tank 117 is higher than a fluid level S1 of the cooling fluid in the main tank 116.

For example, if the extraction rate or the extraction volume of the cooling fluid by the fluid delivery device 130 is greater than a rate at which the cooling fluid flows from the second zone 112 to the first zone 111, the fluid level S2 of the cooling fluid in the secondary tank 117 may be higher than the fluid level S1 of the cooling fluid in the main tank 116.

According to FIG. 1, in this embodiment, the fluid level S2 of the cooling fluid in the secondary tank 117 is higher than the fluid level S1 of the cooling fluid in the main tank 116. Therefore, a height difference between the fluid levels causes the cooling fluid in the secondary tank 117 to have a large hydraulic pressure to automatically flow to the main tank 116 through the communication opening 115 and pass through the first heat exchanger 120. That is to say, the heat dissipation system 100 helps to improve circularity of the cooling fluid by a design of forming the height difference between the fluid levels.

In such a design, the heat dissipation system 100 may not require a mechanism disposed for the flow of the cooling fluid inside the tank 110, and the fluid delivery device 130 is disposed outside the tank 110 and is not required to be installed between sealing pipelines. Therefore, the fluid delivery device 130 is easily installed and replaced without considering a shaft seal used for sealing and without using an expensive and low-efficiency specific pump (e.g., a magnetic drive pump), which is quite cost-saving and convenient for maintenance.

Of course, in other embodiments, in the heat dissipation system 100, the cooling fluid may also pass through the first heat exchanger 120 through the mechanism disposed for the flow of the cooling fluid inside the tank 110 instead of the height difference between the fluid levels.

Compared to a conventional structure in which the cooling fluid flows in a cooling pipeline, which is quite complicated, occupies space, and has a risk of leakage, the cooling fluid of the heat dissipation system 100 in this embodiment flows between different zones in the tank 110. Except for the tank 110 itself, there is no requirement for high-strength sealing, and no complicated pipeline configuration is required. The overall structure is simple and easy to maintain.

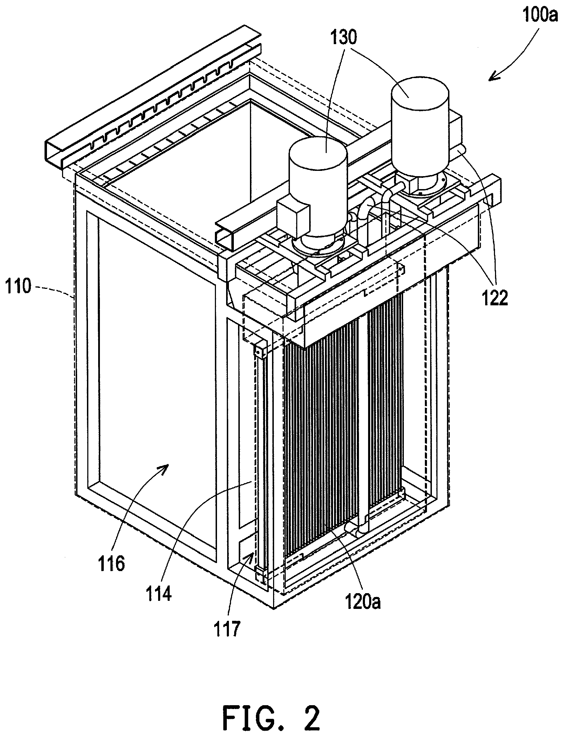

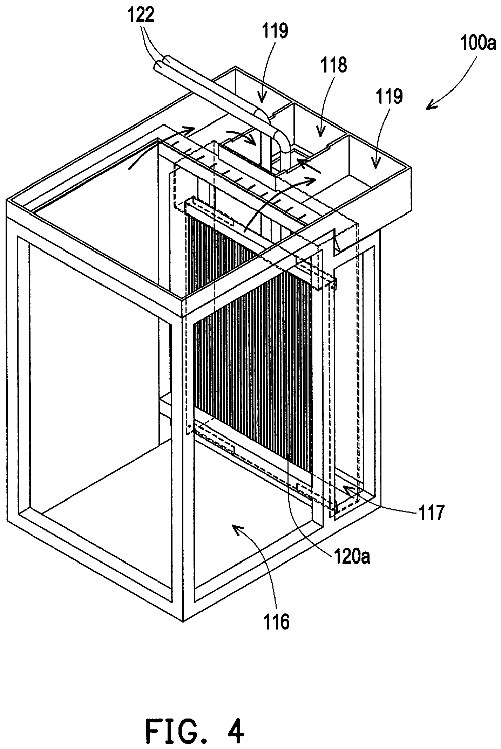

FIGs. 2 to 4 are schematic views of a heat dissipation system from different viewing angles according to another embodiment of the disclosure. It should be noted that the tank 110 is perspective in FIG. 2. In FIG. 4, the tank 110 and the inner partition plate 114 are perspective, and the fluid delivery device 130 is hidden. In FIGs. 2 and 4, the cooling fluid is hidden.

Referring to FIGs. 2 to 3 first, a main difference between a heat dissipation system 100a of FIG. 2 and the heat dissipation system 100 of FIG. 1 lies in a position of a first heat exchanger 120a, and the heat dissipation system 100a may further optionally include a uniform flow plate 140.

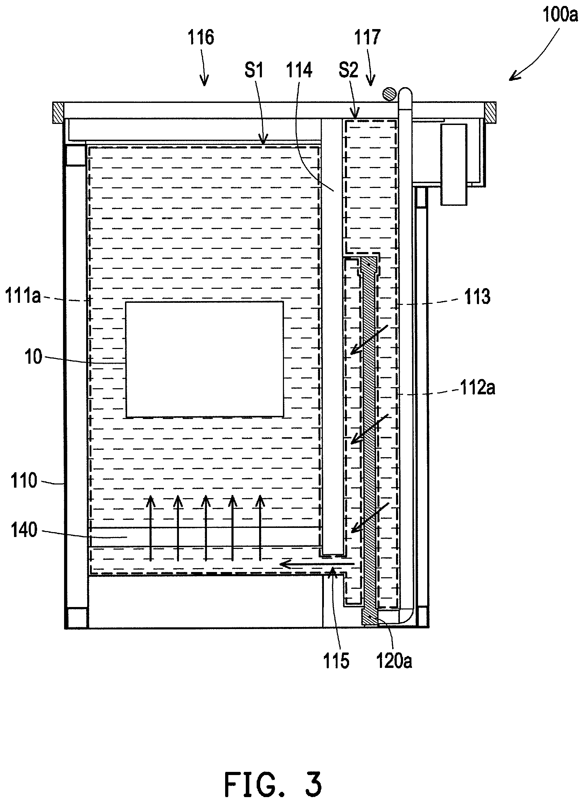

Specifically, according to FIG. 3, in this embodiment, the first heat exchanger 120a is disposed in the secondary tank 117. Therefore, a first zone 111a covers the main tank 116 and a portion of the secondary tank 117 (which is a left portion of the first heat exchanger 120a), and a second zone 112a covers another portion of the secondary tank 117 (which is a right portion of the first heat exchanger 120a).

In this embodiment, the fluid level S2 of the cooling fluid in the second zone 112a is higher than the fluid level S1 of the cooling fluid in the main tank 116. The height difference between the fluid levels enables the cooling fluid in the second zone 112a to have the larger hydraulic pressure, so that the cooling fluid in the second zone 112a passes through the first heat exchanger 120a and flows to the main tank 116 through the communication opening 115.

In addition, in this embodiment, the main tank 116 is provided with the uniform flow plate 140 adjacent to the communication opening 115. There are through holes on the uniform flow plate 140, so that the cooling fluid may flow uniformly in the main tank 116. Of course, in other embodiments, the uniform flow plate 140 may also be omitted, or more uniform flow plates 140 may be disposed.

In addition, in this embodiment, according to FIG. 2, the fluid delivery device 130 is disposed above the secondary tank 117. In FIG. 4, a high-level pool 118 and a pump pool 119 are disposed above the secondary tank 117. The high-level pool 118 is communicated to the secondary tank 117 and is a portion of the second zone 112a (FIG. 3). The cooling fluid in the main tank 116 overflows to the pump pool 119 as shown by an arrow in FIG. 4, and then is pumped to the high-level pool 118 by the fluid delivery device 130 (e.g., the pump) to flow to the second zone 112a. Of course, the high-level pool 118 may also be provided with an overflow pipe to avoid too much cooling fluid and overflow.

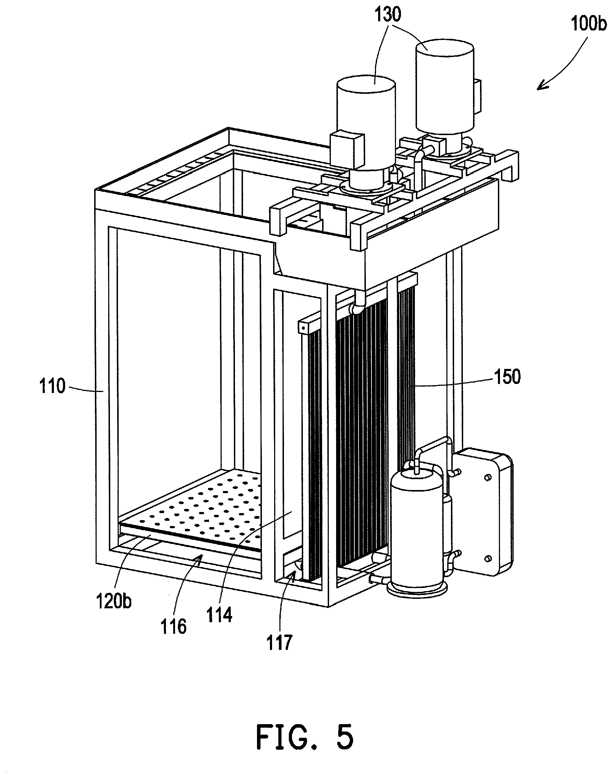

FIGs. 5 to 6 are schematic views of a heat dissipation system from different viewing angles according to another embodiment of the disclosure. It should be noted that in FIG. 5, the tank 110 is perspective, and the cooling fluid is hidden. Referring to FIGs. 5 to 6, a main difference between a heat dissipation system 100b of FIG. 5 and the heat dissipation system 100 of FIG. 1 is that in this embodiment, the heat dissipation system 100b further includes a second heat exchanger 150.

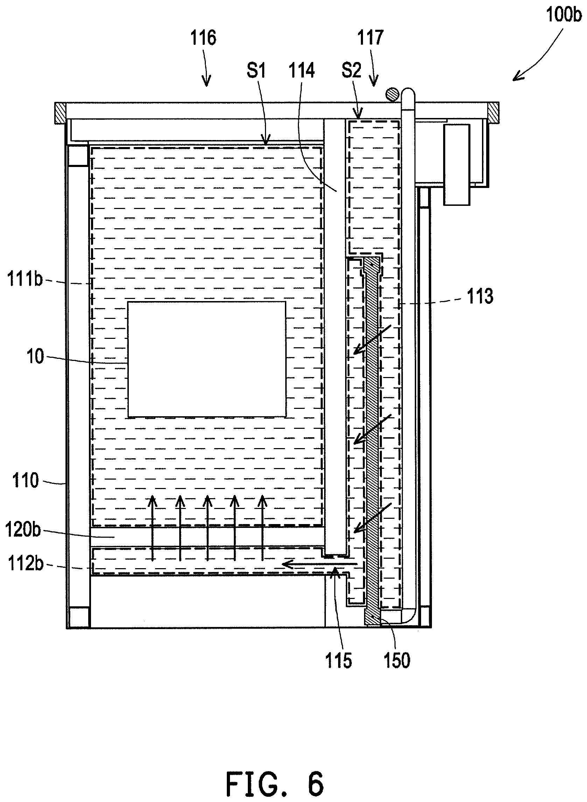

As shown in FIG. 6, a first heat exchanger 120b is disposed in the main tank 116, and the second heat exchanger 150 is disposed in the secondary tank 117. The tank 110 includes a third zone 113, and the second heat exchanger 150 is disposed at a junction of a second zone 112b and the third zone 113.

In this embodiment, a first zone 111b covers a portion of the main tank 116 (which is above the first heat exchanger 120b). The second zone 112b covers another portion of the main tank 116 (which is below the first heat exchanger 120b) and a portion of the secondary tank 117 (which is the left of the second heat exchanger 150). The third zone 113 covers another portion of the secondary tank 117 (which is the right of the second heat exchanger 150).

The fluid delivery device 130 (FIG. 5) delivers the cooling fluid from the first zone 111b to the third zone 113. The fluid level S2 of the cooling fluid in the third zone 113 is higher than the fluid level S1 of the cooling fluid in the main tank 116. The height difference between the fluid levels enables the cooling fluid to flow to the second zone 112b from the third zone 113 after passing through the second heat exchanger 150, flow to the main tank 116 through the communication opening 115, and flow to the first zone 111b after passing through the first heat exchanger 120b, so as to dissipate the heat for electron device 10, and then be delivered to the third zone 113 by the fluid delivery device 130, such that the cycle is formed.

Based on the above, in the heat dissipation system according to the disclosure, the first heat exchanger is disposed at the junction of the first zone and the second zone of the tank to reduce the temperature of the cooling fluid flowing to the first zone. The electronic device may be disposed in the first zone to achieve a heat dissipation effect. The warmed cooling fluid flows from the first zone to the second zone through the fluid delivery device. In the heat dissipation system according to the disclosure, the cooling fluid is adapted to flow to the first zone from the second zone after passing through the first heat exchanger, so as to dissipate the heat for the electronic device immersed in the cooling fluid in the first zone, and then the cooling fluid flows to the second zone through the fluid delivery device, such that the cycle is formed. Therefore, the heat dissipation system according to the disclosure does not require the complicated cooling pipelines, and the overall structure is quite simple.

## Claims

1. A heat dissipation system (100, 100a, 100b), adapted to dissipate heat for an electronic device (10), comprising:
a tank (110) comprising a first zone (111, 111a, 111b) and a second zone (112, 112a, 112b), wherein a cooling fluid is located in the first zone (111, 111a, 111b) and the second zone (112, 112a, 112b), and the electronic device (10) is adapted to be disposed in the first zone (111, 111a, 111b) and immersed in the cooling fluid;
a first heat exchanger (120, 120a, 120b) disposed at a junction of the first zone (111, 111a, 111b) and the second zone (112, 112a, 112b) to reduce a temperature of the cooling fluid; and
a fluid delivery device (130) enabling the cooling fluid to flow from the first zone (111, 111a, 111b) to the second zone (112, 112a, 112b), wherein the cooling fluid is adapted to flow to the first zone (111, 1 1 1a, 111b) from the second zone (112, 112a, 112b) after passing through the first heat exchanger (120, 120a, 120b), so as to dissipate the heat for the electronic device (10), and then flows to the second zone (112, 112a, 112b) through the fluid delivery device (130), such that a cycle is formed.

2. The heat dissipation system (100, 100a, 100b) according to claim 1, wherein the tank (110) comprises an inner partition plate (114) and a communication opening (115) adjacent to a bottom of the tank (110), the inner partition plate (114) separates the tank (110) into a main tank (116) and a secondary tank (117), the main tank (116) is communicated to the secondary tank (117) through the communication opening (115), and the electronic device (10) is disposed in the main tank (116).

3. The heat dissipation system (100, 100a, 100b) according to claim 2, wherein the first heat exchanger (120, 120a, 120b) is disposed in the main tank (116), the first zone (111, 111a, 111b) covers a portion of the main tank (116), and the second zone (112, 112a, 112b) covers another portion of the main tank (116) and the secondary tank (117).

4. The heat dissipation system (100, 100a, 100b) according to claim 3, wherein a fluid level (S1, S2) of the cooling fluid in the secondary tank (117) is higher than a fluid level (S1, S2) of the cooling fluid in the main tank (116), so that the cooling fluid in the secondary tank (117) flows to the main tank (116) through the communication opening (115), and passes through the first heat exchanger (120, 120a, 120b).

5. The heat dissipation system (100, 100a, 100b) according to claim 2, wherein the first heat exchanger (120, 120a, 120b) is disposed in the secondary tank (117), the first zone (111, 111a, 111b) covers the main tank (116) and a portion of the secondary tank (117), and the second zone (112, 112a, 112b) covers another portion of the secondary tank (117).

6. The heat dissipation system (100, 100a, 100b) according to claim 5, wherein a fluid level (S1, S2) of the cooling fluid in the second zone (112, 112a, 112b) is higher than a fluid level (S1, S2) of the cooling fluid in the main tank (116), and the cooling fluid in the second zone (112, 112a, 112b) passes through the first heat exchanger (120, 120a, 120b) and flows to the main tank (116) through the communication opening (115).

7. The heat dissipation system (100, 100a, 100b) according to claim 2, further comprising a uniform flow plate (140) disposed in the main tank (116) adjacent to the communication opening (115).

8. The heat dissipation system (100, 100a, 100b) according to claim 1, wherein the tank (110) comprises a third zone (113), and the heat dissipation system (100, 100a, 100b) further comprises:
a second heat exchanger (150) disposed at a junction of the second zone (112, 112a, 112b) and the third zone (113), wherein the fluid delivery device (130) delivers the cooling fluid from the first zone (111, 111a, 111b) to the third zone (113), the cooling fluid flows to the second zone (112, 112a, 112b) from the third zone (113) after passing through the second heat exchanger (150), then flows to the first zone (111, 111a, 111b) after passing through the first heat exchanger (120, 120a, 120b), so as to dissipate the heat for the electronic device (10), and is delivered to the third zone (113) by the fluid delivery device (130), such that the cycle is formed.

9. The heat dissipation system (100, 100a, 100b) according to claim 8, wherein the tank (110) comprises an inner partition plate (114) and a communication opening (115) located at a bottom of the tank (110), the inner partition plate (114) separates the tank (110) into a main tank (116) and a secondary tank (117), the main tank (116) is communicated to the secondary tank (117) through the communication opening (115), the electronic device (10) is disposed in the main tank (116), the first heat exchanger (120, 120a, 120b) is disposed in the main tank (116), and the second heat exchanger (150) is disposed in the secondary tank (117).

10. The heat dissipation system (100, 100a, 100b) according to claim 9, wherein the first zone (111, 111a, 111b) covers a portion of the main tank (116), the second zone (112, 112a, 112b) covers another portion of the main tank (116) and a portion of the secondary tank (117), and the third zone (113) covers another portion of the secondary tank (117).

11. The heat dissipation system (100, 100a, 100b) according to claim 8, wherein a fluid level (SI, S2) of the cooling fluid in the third zone (113) is higher than a fluid level (S1, S2) of the cooling fluid in the main tank (116), the cooling fluid flows to the second zone (112, 112a, 112b) from the third zone (113) through the second heat exchanger (150), flows to the main tank (116) through the communication opening (115), and flows to the first zone (111, 111a, 111b) through the first heat exchanger (120, 120a, 120b).
